Europäisches Patentamt

**European Patent Office**

**Office européen des brevets**

(11) Publication number: **0 279 537 B1**

# EUROPEAN PATENT SPECIFICATION

(45) Date of publication of patent specification: **29.12.93** (51) Int. Cl.⁵: **G11B 5/39**, G01R 33/06

(21) Application number: **88300685.0**

(22) Date of filing: **27.01.88**

(54) **Magnetoresistive sensor and process for its manufacture.**

(30) Priority: **17.02.87 US 15203**

(43) Date of publication of application:
**24.08.88 Bulletin 88/34**

(45) Publication of the grant of the patent:
**29.12.93 Bulletin 93/52**

(84) Designated Contracting States:
**DE FR GB**

(56) References cited:
**EP-A- 0 100 841**
**GB-A- 2 146 482**
**US-A- 4 103 315**

**PATENT ABSTRACTS OF JAPAN, vol. 11, no. 22 (P-538)(2469), 21 January 1987**

**PATENT ABSTRACTS OF JAPAN, vol. 7, no. 176 (P-214)(1321), 4 August 1983**

(73) Proprietor: **SEAGATE TECHNOLOGY INTERNATIONAL**
**c/o Maples & Calder,**
**P.O. Box 309**
**Georgetown, Grand Cayman Island(KY)**

(72) Inventor: **Mowry, Greg Stephen**
**13905 James Avenue South**
**Burnsville Minnesota 55337(US)**

(74) Representative: **Kenyon, Sarah Elizabeth et al**
**J. Miller & Co.**
**34 Bedford Row**
**Holborn**
**London WC1R 4JH (GB)**

## Description

This invention relates to magnetoresistive sensors, for example, for magnetoresistive heads for magnetic disk drives.

A typical magnetoresistive head is disclosed in GB-A-2146 482. The head comprises a sensor disposed between a shield and one of a pair of write poles.

Magnetoresistive sensors, which are responsive to change in resistivity caused by the presence of magnetic fields, are increasingly employed as read transducers in heads of magnetic disk drives primarily because the change of resistivity is independent of disk speed, depending only on the magnetic flux, and secondarily because sensor outputs may be scaled by sense current.

Magnetoresistive sensors typically comprise a thin strip of NiFe alloy (Permalloy) magnetised along an easy axis of low coercivity. Many other ferromagnetic alloys are also candidates. The magnetoresistive sensor is usually mounted in a head such that the easy axis is transverse to the direction of rotation of a disk and parallel to the plane of the disk. The magnetic flux from the disk causes rotation of the magnetisation vector of the magnetoresistive sensor which, in turn, causes a change in resistivity to a sense current flowing between lateral contacts. The resistivity varies approximately according to the cosine-square of the angle between the magnetisation vector and the current vector, i.e.:

$$\Delta \rho = \rho \max \times \cos^2\theta$$

where $\theta$ is the angle between the magnetisation and current vectors and $\rho$ is the resistivity.
Due to this cosine-square relationship, if the magnetisation and current vectors are initially aligned, the initial change in resistivity due to disk magnetic flux is low and unidirectional. Typically, therefore, either the easy axis magnetisation vector or the current vector is biased to approximately 45° to increase responsiveness to angular change in the magnetisation vector and to linearise the output of the magnetoresistive sensor.

A first problem encountered with magnetoresistive sensors is Barkhausen noise caused by the irreversible motion of magnetic domains in the presence of an applied field, i.e. coherent rotation of the magnetisation vector is non-uniform and suppressed, and depends upon domain wall behaviour. This noise mechanism is eliminated by creating a single magnetic domain in a sense current region of the magnetoresistive sensor.

Many different means have been employed both to linearise the output of the magnetoresistive sensor and to provide for a single domain in the sense current region.

One known solution, to cause a single domain in the sense current region for example, is to increase the length of a magnetoresistive sensor relative to its height. Multiple closure domains are known to occur at the ends of long magnetoresistive sensors. These migrate towards the centre under the influence of external fields. However, long magnetoresistive sensors may be subject to cross talk in lateral portions thereof and may conduct magnetic flux from adjacent tracks to the sense current region of the magnetoresistive sensor. Short magnetoresistive sensors, in contrast, almost invariably spontaneously "fracture" into multiple domains.

Another known solution of providing single domains in the sense current region is by shaping the magnetoresistive sensor so as to reduce edge demagnetising fields while producing a relatively short physical dimension in the sense current region (see e.g. Figure 4a of US-A-4,503,394 where upper and lower horizontal sections with opposed easy axes are connected at the ends with vertical sections to comprise an endless loop). See also US-A-4,555,740 in which a magnetoresistive sensor has two intermediate, upwardly extending legs. However, such shaped magnetoresistive sensors suffer from a second problem in that sensors "fracture" into multiple domains in the presence of strong transverse magnetic fields. Strong transverse magnetic fields are caused by the inductive write poles between which the magnetoresistive sensors are conventionally mounted (the poles act as soft magnetic shields to isolate the magnetoresistive sensor from magnetic fields not directly adjacent thereto).

A third known solution of forming single domains is by providing a longitudinal magnetic field in "long" or shaped magnetoresistive sensors, prior to reading. Such a magnetic field has to be strong enough to cause the formation of a relatively stable, single domain in the central sense current region. This initialisation field is generally provided by a barber pole, which also has the advantage that it can be used to cant the direction of the sense current relative to the easy axis magnetic vector. An example of such can be found in the aforementioned GB-A-2146482 which has ferromagnetic material (14) disposed at the ends of the sensor for exchange biasing and an external field applied along the longitudinal direction.

A fourth known solution, particularly for short magnetoresistive sensors, is to maintain single domains by permanent longitudinal biasing from adjacent permanent magnets or atomically coupled antiferromagnetic material which results in exchange-biasing. Such biasing is also provided, in some applications, to transverse-bias the magnetic vector away from the easy axis to linearise the output of the magnetoresistive sensor, as mentioned above.

However, both of these biasing schemes (initialisation and permanent) have the drawback in that the biasing magnetic field could adversely affect the information pre-recorded on the magnetic disk, and further, a permanent biasing field (both transverse and longitudinal) increases the effective anisotropy of the magnetoresistive sensor thereby decreasing sensitivity to disk magnetic flux. The barber pole (canted current) design has the additional disadvantage that the effective length of the magnetoresistive sensor area is less than the longitudinal distance between canted contacts of the magnetoresistive sensor. The barber pole design also requires precise lithographic processes to apply the canted contacts and shortening stripes.

Exchange-biasing is not commonly used in practice because of the presence of two dissimilar materials (the magnetoresistive material and the antiferromagnetic material) at an exposed interface. This can lead to corrosion which can destroy a head. Further, because exchange-biasing is a quantum-mechanical interaction effect, reliable atomic interaction is imperative, but such processing is difficult and yields are low. Further, the effect has a strong temperature dependence, being substantially reduced in the typical operating environments of the conventional disk drives.

Accordingly, an aim of the present invention is to provide a magnetoresistive sensor which can even be positioned between the pole tips of the inductive write apparatus but reduce Barkhausen noise whilst substantially obviating the problems encountered with the aforementioned known solutions.

According to one aspect of the present invention there is provided an elongated magnetoresistive sensor characterised by having a central sense region and exchange-biasing antiferromagnetic material exchange coupled to the sensor only outside the central sense region.

In one embodiment the sensor has a longitudinal section in which the central sense region is centrally located and a pair of vertically extending sections coupled to the longitudinal section outside the central sense region.

Preferably the sensor has a pseudo-ellipsoid shape.

Said exchange-bias material may be recessed a short distance away from said edge.

The sensor preferably includes two electrical contacts contacting said exchange-biasing material. The contacts may have parallel canted surfaces in said central sense region. Alternatively said contacts may have uncanted parallel surfaces in the central sense region.

The sensor may include a constant current source connected between each of said contacts and a voltage sensing circuit further connected between each of said contacts.

According to another aspect of the present invention there is provided a process for making a magnetoresistive sensor characterised by comprising the steps of: depositing a thin layer of magnetoresistive material in a magnetic field; patterning the magnetoresistive material to define a sensor strip; depositing on the magneto-resistive material a layer of photo resist; patterning the photo resist to cover only a central sense region; depositing a layer of exchange-biasing antiferro magnetic material on the magnetoresistive material and photoresist; depositing a layer of contact material; and lift-off processing to remove the photo resist and the exchange-biasing material and contact material adhering thereto, to define a magnetoresistive sensor having a central sense region without exchange-biasing material and with exchange biasing material atomically coupled to the sensor outside the central sense region and contacts contacting the exchange biasing material.

The process may include patterning the photo resist to cover a recess region on each side of the central region and patterning the magnetoresistive material and exchange-biasing material to define a magnetoresistive strip having a central sense region and two recess regions on each side of the central sense region without exchange-biasing material and with exchange-biasing material atomically coupled to the strip outside the central sense and recess regions.

It is noted that EP-A-0279535 and EP-A-0279536 of the same applicant relate to a magnetic head comprising a magnetoresistive sensor.

The invention is illustrated, merely by way of example, in the accompanying drawings, in which:-

Figure 1 is an elevation of a pseudo-ellipsoidal magnetoresistive sensor according to the present invention;

Figure 2 is an elongated magnetoresistive sensor according to the present invention having upwardly projecting ends with exchange-biasing material;

Figure 3 illustrates the essential steps for depositing exchange-biasing only on the ends of a magnetoresistive sensor according to the present invention;

Figure 4 is a magnetoresistive sensor of Figure 1 having exchange-biasing material at the ends;

Figure 5 is a cross section of a magnetoresistive head having a magnetoresistive sensor according to the present invention with recessed exchange-biasing material;

Figure 6 shows a layer structure of a double-gap magnetoresistive head with a magnetoresistive sensor according to the present invention;

Figure 7 is an elevational view of the essential elements for a double-gap magnetoresistive head with a magnetoresistive sensor according to the present invention;

Figure 8 shows a known magnetoresistive sensor with canted current contacts and electrical circuits connected thereto;

Figure 9 shows an easy axis pattern-biased magnetoresistive sensor according to the present invention and relaxed canted current contacts;

Figure 10 shows an easy axis pattern-biased pseudo-ellipsoidal magnetoresistive sensor according to the present invention;

Figure 11 shows the relative response of a magnetoresistive sensor according to the present invention in linear and non-liner modes; and

Figure 12 is a pseudo ellipsoidal magnetoresistive sensor according to the present invention having uncanted contacts for a non-linear response.

In the drawings, like parts have been designated by the same reference numerals.

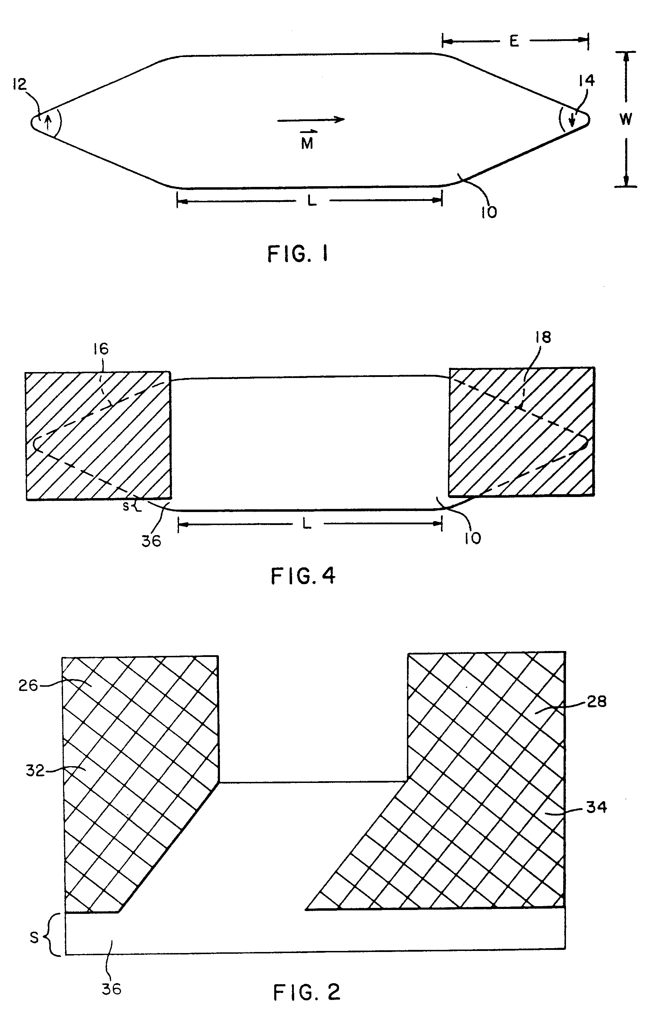

Figure 1 in this elevational view shows a pseudo-ellipsoidal magnetoresistive sensor 10 magnetised along the easy axis M. A central sense region L has relatively flat sides, rather than curved as in a true ellipse. The aspect ratio, AR, of overall length to height is less than 3, but can be greater with no loss of effect. From the central region L, the sides converge to apexes in which small magnetic domains 12,14 spontaneously form. Preferably $W \leq L$ and E (the length of an apex) is of the order of L at a minimum, having no known maximum. The structure forms a very stable central region single domain indicated by the large rightwardly directed arrow.

Experimentation with this structure shows that a thin layer of 20-50nm (200-500 angstroms) Ni:82 Fe:18 alloy, with an overall length of 25 $\mu$m, a central region L of 9 $\mu$m, and a width W of 8 $\mu$m requires 2800A/m (35 Oe) to switch the magnetisation vector of the central region to the hard axis, while only 60A/m (0.75 Oe) is required in an unpatterned bulk film. This translates to a factor of 46 improvement.

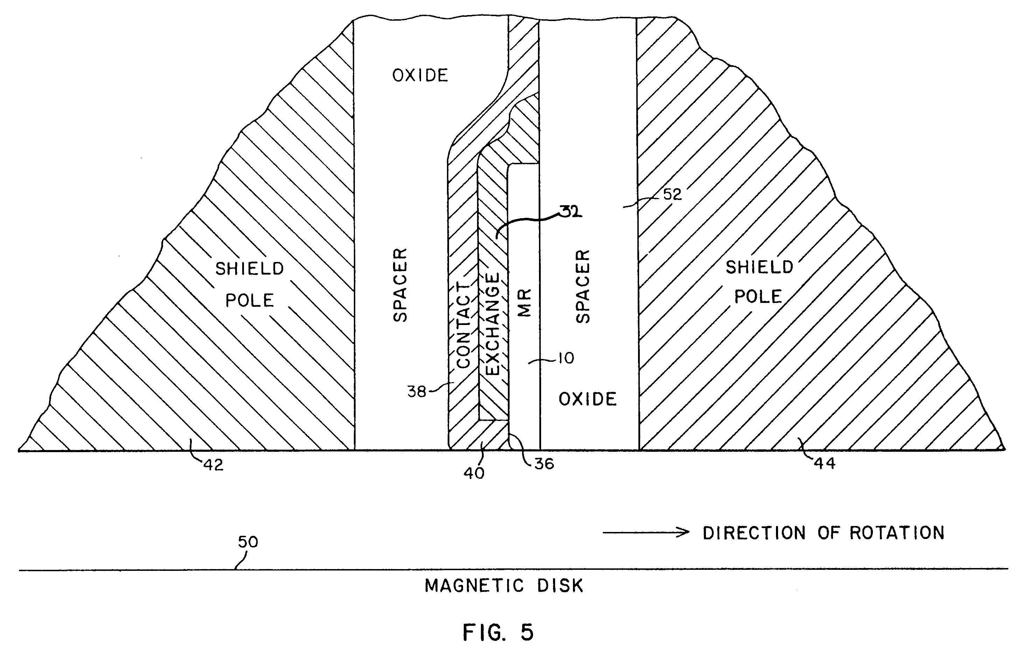

Where high transverse fields can be expected, such as when an unshielded magnetoresistive sensor is placed between or next to the poles of an inductive write head, longitudinal biasing is still required to initialise or maintain a single domain state. As hitherto discussed, there are many different means for accomplishing this. For example, barber pole biasing generates a longitudinal field. In addition permanent magnetic biasing or exchange-biasing can also provide a longitudinal field. A novel stabilisation means is disclosed in Figure 4.

Prior exchange stabilisation/biasing techniques have been typically prepared by first depositing a ferromagnetic layer upon a substrate and then depositing an antiferromagnetic layer upon the ferromagnetic layer such that, after patterning, the two layers coincide.

Exchange-biasing can result in a signal loss due to shunting effects. Longitudinal exchange fields have a negative temperature dependence. Finally, the possibility exists of corrosion due to bimetallic film structure.

The domain stabilisation process can be understood by recognising that if the magnetisation is pinned at the boundaries of a thin film strip then the equilibrium magnetisation direction can be controlled in the central region between the boundaries. By depositing FeMn in crosshatched regions 16,18 shown in Figure 4, the previously indicated drawbacks to standard exchange-biasing techniques can be avoided. First, since there is no exchange bias material in the central region L, there can be no signal loss due to current shunting. Secondly, this stabilisation technique is extremely temperature insensitive since the requirement is made that only the direction of the magnetisation be fixed: not the magnitude of the longitudinal exchange field. Finally, by proper patterning, the bimetallic interface can be eliminated at any exposed edge. Preferably the exchange bias material used is FeMn because of its electrical conductivity.

An embodiment of the magnetoresistive sensor having a stable single domain central region employing exchange-biased ends is shown in Figure 2. Here, the magnetised alloy strip has a C-shape with a relatively narrow central region and with the lateral ends having upwardly extending legs 26,28 for conducting the demagnetising field further away from the central region. This improves the stability of the single domain in the central region. Exchange-bias material 32,34 and contact metallisation (not shown) are applied to these ends which generally conforms to the pattern of canted current end contacts (not shown). This pattern of exchange-bias material eliminates edge and end domains and provides a stable central single domain sense current region. To avoid the aforementioned corrosion problem at exposed interfaces, a recess 36 with a width S is provided between the exchange-bias material and a lower edge of the magnetoresistive sensor 10, the lower edge being that exposed to the magnetic disk in most designs.

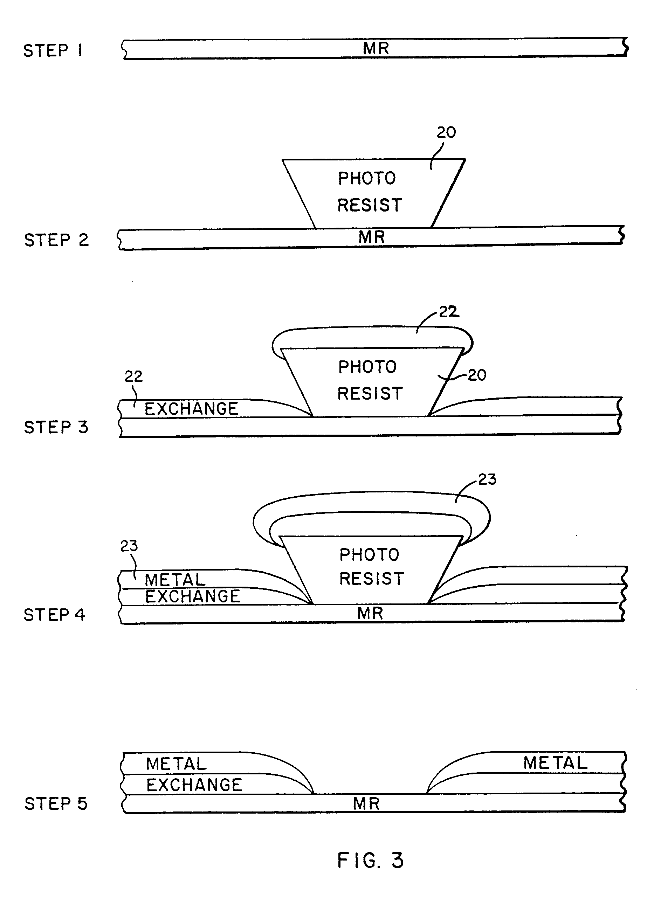

The process for forming the structure shown in Figure 2 is shown in Figure 3. Step 1: a strip of magnetoresistive material Mr is evaporated, sputtered or the like on a substrate (not shown for the purpose of clarity), in a uniform magnetic field directed along an easy axis, and patterned. Step 2:

a photo resist layer 20 is laid down and patterned using conventional processes to form an island with inwardly inclined sides. Step 3: exchange-bias material 22 is evaporated, sputtered or the like onto the magnetoresistive material Mr and the photo resist layer 20. Step 4: contact metallisation 23 is deposited. Step 5: using a lift-off process, the photo resist layer 20 with the exchange-bias material 22 and metallisation 23 thereon are removed.

The pseudo-ellipsoidal magnetoresistive sensor with exchange-bias material on its ends extending to a flattened central region L as shown in figure 4 is also formed by the process of figure 2.

Figure 5 shows a vertical cross-section of the exchange-biased magnetoresistive sensor 10 of either figure 2 or figure 4 mounted between shields 42,44 above a magnetic disk 50. The exchange-bias material 32 is recessed a short distance above a lower surface of the magnetoresistive element adjacent to the magnetic disk 50 to form the recess 36 and contact metal 38 has a leg 40 extending to the lower edge of the magnetoresistive sensor 10 to shield the exchange-bias material 32 from exposure. At least one of the shields 42,44 also comprises one of the poles of an inductive write apparatus (not shown). The shields are separated via spacers 52 typically composed of a non-magnetic material such as $AL_2O_3$. By providing the recess 36, the contact material 38 has the leg 40 directly contacting the lower surface of the magnetoresistive sensor 10. This shields the exchange-bias material 32 from exposure. Most heads land on the surface of the magnetic disk 50 when disk rotation stops, burnishing small amounts of the head material away. The amount of the recess 36 versus the degree of burnishing determines the lifetime of the head until the exchange-bias material is exposed leading to potential corrosion.

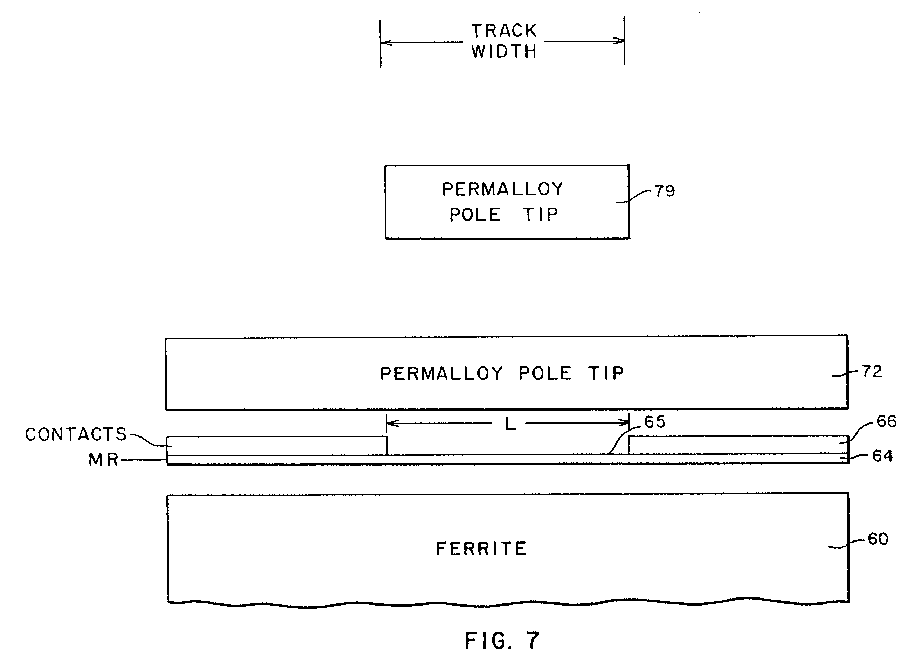

The existence of strong transverse magnetic fields causes relatively stable single domain regions to "fracture" into multiple domains, the source of Barkhausen noise. Strong magnetic fields are present between pole tips of the inductive write apparatus, the conventional location of most magnetoresistive sensors. To reduce the effect of the inductive write pole tips on the magnetoresistive sensor, it is known to place it along side the pole tips (see US-A-4,321,641). This type of structure requires a soft magnetic shield, a shield/trailing pole tip, and a leading pole tip. The design of US-A-4,321,641 is not entirely satisfactory, primarily due to the extension of magnetoresistive material (see Figure 4 or Figure 7) beyond a shield of a trailing pole tip.

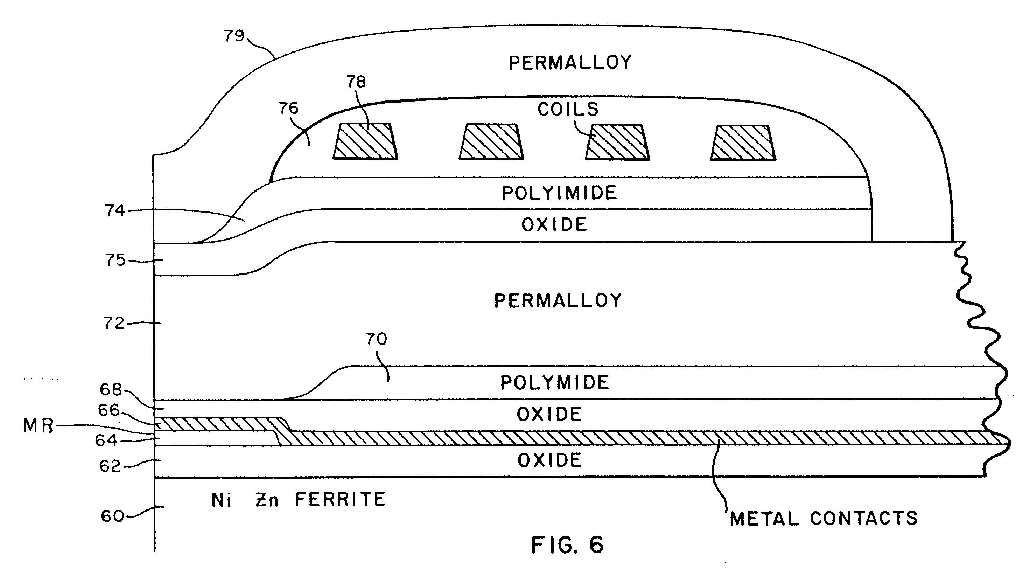

The magnetoresistive head shown in Figures 6 and 7 hereof provides a magnetically very quiet region for the magnetoresistive sensor.

Figure 6 is a cross-section of the essential elements of a magnetoresistive sensor. A layer 62 of oxide, preferably aluminium oxide, is deposited upon a soft magnetic substrate 60, preferably NiZn. Next, magnetoresistive sensor material 64 is deposited in a magnetic field and patterned. Exchange-bias material is then deposited and patterned. Metal contacts 66 are then deposited on the magnetoresistive sensor material 64. A second layer of oxide 68 is then deposited. The two oxide layers 62,68 comprise a read gap. A layer of polyimide or photo resist 70 is then deposited and patterned as shown to remove the layer adjacent a gap end of the magnetoresistive head. Next a layer 72 of ferromagnetic material is laid down, preferably of NiFe (Permalloy). This layer 72 comprises a trailing pole/shield. Next, a write gap oxide layer 75 of, for example, aluminium oxide or silicon dioxide, is deposited followed by a second layer 74 of polyimide or photo resist. Metal coils 78 are deposited and patterned. Two layers 76 of polyimide or photo resist are deposited and patterned to remove the portion not adjacent the coils 78. Finally, a final layer 79 of a ferromagnetic material comprises the leading pole/shield and is deposited to encompass the coils and contact the layer 72 to form a continuous flux path. After the magnetoresistive sensor is formed, it is typically sealed in a suitable non-magnetic material and the gap end processed, e.g. by lapping to expose the end gap or gaps and providing a reliable gap height.

Figure 7 is an end view of the essential elements of a magnetoresistive sensor. Spacing layers are omitted for clarity. Shown in the Figure are the substrate 60, the magnetoresistive sensor material 64, its lateral metal contact 66 defining a central sense current region 65 of length L, and the ferromagnetic trailing pole/shield 72, and the leading pole/shield 79. The length of the leading pole/shield 79 defines the written track width via magnetic mirroring with the trailing pole/shield 72. This length corresponds to the length L (plus a processing guard band wherein the length L is intentionally made smaller than the written track width to avoid possible cross talk) of the central sense current region 65 of the magnetoresistive sensor material 64. Typically, the magnetoresistive sensor material is longer than a track width to assist in providing a stable single domain in the central sense current region 65. It is essential that the trailing pole/shield 72 is as long as the magnetoresistive sensor material 64 to shield it completely from side fringing fields originating during the writing process. This makes the leading and trailing poles/shields 79,72 of different lengths. However, it has been discovered that this does not affect the written track width, which is defined by the length of the leading pole/shield 79 and the above mentioned mirroring effects.

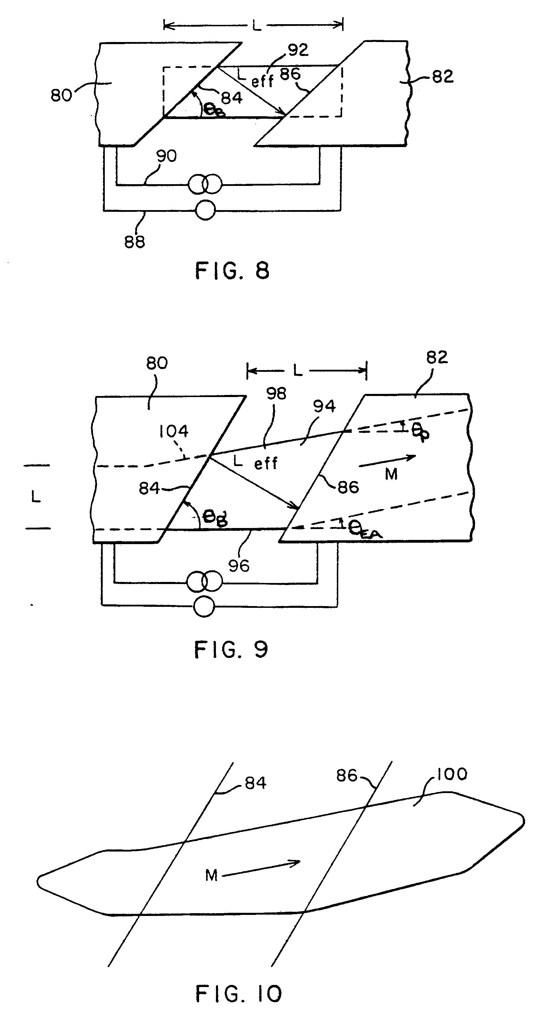

For many applications, such as audio applications, linear operation of a magnetoresistive sensor is desirable. As mentioned above, linearisation either requires the canting of the easy axis magnetisation vector or the canting of the current vector. Canting of the magnetisation vector typically increases anisotropy and reduces the range of resistivity change and thus sensitivity of the magnetoresistive sensor. Canting the current likewise causes a comparable loss in sensitivity as better illustrated in Figure 8.

Figure 8 shows a typical canted current biasing technique wherein conductors 80,82, intimately contacting a magnetoresistive strip 92 of length L provide a canted current from a source 88 generally in the direction $L_{eff}$ between the contacts. The current direction is generally perpendicular to the surfaces 84,86 of the conductors. These surfaces are generally canted at an angle of $\theta_B$ of between 40° and 45° for greatest linearity and sensitivity. The change in resistivity is sensed by means 90 (which can be a voltage sensor if the source 88 is a constant current source, a transimpedance current sensor if the source 88 is a constant voltage source, or a power sensor if the source 88 is a "soft" source). The change in resistivity is generally proportional to the length $L_{eff}$ which is less than the length L between the conductors in the longitudinal direction. The length L, in turn, is approximately the track width of one track and defines the length of the sense current region. Thus, the sensitivity of the magnetoresistive sensor is reduced by the ratio $L_{eff}/L$. Making $L_{eff}$ comparable to track width is not desirable because the length L would then be long enough to pick up significant cross talk from adjacent tracks.

Figure 9 shows an improved canted magnetoresistive sensor 94 which relaxes the cant of the surfaces 84,86 of the contacts 80,82 to an angle $\theta_{B'}$ of approximately 50°. This substantially increases $L_{eff}$ and thereby sensitivity while maintaining the approximately 40° to 45° angle with the easy axis. The reason for this is that the magnetoresistive sensor is patterned such that its easy axis is itself canted by an angle $\theta_{EA}$ of approximately 10°.

The surfaces 84,86 are each canted at an angle $\theta_{B'}$ which is preferably 50°. A lower edge 96 of the magnetoresistive sensor is parallel to the magnetic disk surface but an upper edge 98 is patterned at an angle of $\theta_P$ thereto to give a resultant easy axis magnetisation vector M at an angle $\theta_{EA}$ of approximately 10° to the lower edge 96.

The magnetoresistive sensor 94 is formed from a bulk film deposited on a suitable substrate in an uniform magnetic field directed parallel to the lower edge 96. The bulk film is thereafter patterned using conventional lithographic techniques to form the pattern illustrated with the upper edge 98 forming an upwardly extending angle with the lower edge 96. This shape inherently cants the easy axis magnetisation vector M upwards, though to a lesser degree than the angle of the upper edge 98. To achieve the net easy axis rotation of 10° it will be appreciated that the strength of the undeflected easy axis vector with the size, length, thickness, and composition of the magnetoresistive material with the angle of the upper edge to the lower edge will have to be balanced.

In this embodiment, the magnetoresistive sensor 94 is composed of 80:20 NiFe alloy, approximately 50nm (500 angstroms) thick, with L approximately equal to 9 $\mu$m, h (the height of the magnetoresistive sensor at a point 104) approximately equal to 8 $\mu$m, and $\theta_P$ is 10°, $\theta_{B'}$ is 50° and $\theta_{EA}$ is 10°. Figure 10 shows an example of a canted easy axis pseudo-ellipsoidal magnetoresistive sensor 100 and its relative orientation with surfaces 84,86 (the conductors 80,82 are not shown in Figure 10).

For most digital applications, data is written on the disk in code (e.g. variable length 2,7) where only the location of a transition (pulse peak) rather than its direction and magnitude is important. Pulse amplitude serves the function of triggering qualifiers to discern between signal and noise. Thus exception for improved initial sensitivity to magnetisation vector rotation, there is no good reason to operate the magnetoresistive sensor linearly. Thus the magnetoresistive sensor could be provided with no transverse biasing at all, except perhaps the patterned-biasing just described, could be operated the in a non-linear mode and the magnetoresistive sensor and disk flux could be designed such that the magnetisation vector rotation in response to disk flux is of the order of 40° to 50°.

Because the location of a transition (pulse peak) is important, the signal from the disk is conventionally differentiated and the zero crossing detected. Noise makes the location of the zero crossing uncertain, and for this reason, noise ultimately limits the data density. However, by not transversely biasing the magnetoresistive sensor, it will operate in its non-linear mode and the differential will have a steeper zero crossing slope than that of a linearly biased magnetoresistive sensor. This increased zero crossing slope leads to less sensitivity to noise, and to a more accurate detection of zero crossing locations, all other things being equal.

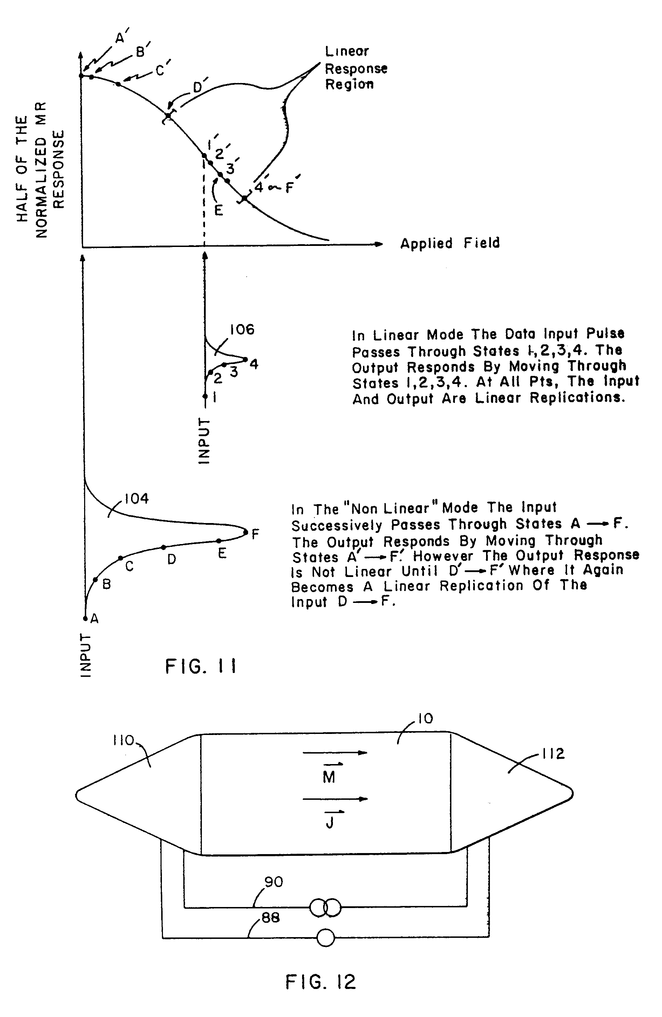

In order to achieve a proper non-linear signal out of the magnetoresistive sensor, the magnetisation vector must be made to rotate to a greater degree than in the transversely biased case (see Figure 11 for an illustration of the principle). The upper portion of Figure 11 shows graphically half the normalised magnetoresistive response. The lower portion of Figure 11 shows graphically two disk flux input signals 104,106, the signal 104 representing the input signal to a non-linear magnetoresistive sensor, and the signal 106 representing the input to a linear magnetoresistive sensor. While the two signals 104,106 are shown with greatly different magnitudes, they may actually be of the same magnitude if the relative response of the magnetoresistive sensor is proportional to the relative difference shown. Actually, it may be preferable to adjust the relative response of both the disk and the magnetoresistive sensor.

In a linear mode of operation, the signal 106 passes through states 1, 2, 3 and 4 and the magnetoresistive sensor responds by moving through resistivity states $1'$, $2'$, $3'$ and $4'$ (for an oppositely polarised pulse, the states would be on the opposite side of the state $1'$). For all states, the inputs and outputs are linear replications.

In a non-linear mode, the signal 104 passes through states A to F and the sensor responds with states $A'$ to $F'$ (an oppositely polarised signal pulse would result in the same output, but from the other half of the resistivity curve). The output is non-linear until region $D'$ to $F'$, where it again becomes a linear replication.

It can be seen from Figure 11 that the total response of the non-linear magnetoresistive sensor (from $A'$ to $F'$) is greater than the total response from the linear magnetoresistive sensor (from $1'$ to $4'$). Thus total sensitivity is greater, and transition centres (pulse peaks) can be more accurately located. Actual output of the magnetoresistive sensor is increased by 25 to 30%.

While there are many possible choices of materials to achieve the response indicated in Figure 11, the preferred choice is a magnetoresistive sensor comprised of permalloy and a magnetic disk material with sufficient flux to yield the magnetisation vector rotation indicated with a magnetoresistive sensor mounted on a conventional head.

Figure 12 shows a magnetoresistive sensor 10 of pseudo-ellipsoidal shape, a constant current source 88 and a voltage sensor 90. This magnetoresistive sensor is preferably mounted in the double gap head of Figures 6 and 7. By providing no biasing whatsoever, the sensor would operate in a non-linear mode. Its shape and location in the shielded second gap of the double gap head might maintain the magnetoresistive sensor in a single domain state. If this implementation is not robust enough for a given application, then stability can be further enhanced by providing exchange-biasing antiferromagnetic material in regions 110,112 as previously described.

It will be appreciated that, as in Figure 9, the other illustrated embodiments have the easy magnetisation axis canted upwardly from a line parallel to a lower edge of the magnetoresistive sensor.

## Claims

1. An elongated magnetoresistive sensor characterised by having a central sense region and exchange-biasing antiferromagnetic material (32,34) exchange-coupled to the sensor only outside the central sense region.

2. A sensor as claimed in claim 1 characterised by having a longitudinal section in which the central sense region is centrally located and a pair of vertically extending sections (26,28) coupled to the longitudinal section outside the central sense region.

3. A sensor as claimed in any preceding claim characterised by having a pseudo-ellipsoid shape.

4. A sensor as claimed in any preceding claim characterised by having an edge, said exchange-biasing material (16,18) being recessed a short distance (36) away from said edge.

5. A sensor as claimed in any preceding claim characterised by including electrical contacts contacting said exchange-biasing material (32,34).

6. A sensor as claimed in claim 5 characterised in that said contacts have parallel canted surfaces in said central sense region.

7. A sensor as claimed in claim 5 characterised in that said contacts have uncanted parallel surfaces in the central sense region.

8. A sensor as claimed in any of claims 5 to 7 characterised by a constant current source (88) connected between each of said contacts and a voltage sensing circuit (90) further connected between each of said contacts.

9. A process for making a magnetoresistive sensor characterised by comprising the steps of: depositing a thin layer of magnetoresistive material (Mr) in a magnetic field; patterning the magnetoresistive material to define a sensor strip; depositing on the magnetoresistive material a layer (20) of photo resist; patterning the photo resist to cover only a central sense region; depositing a layer of exchange-biasing antiferromagnetic material (22) on the magnetoresistive material and photo resist; depositing a layer of contact material (23); and lift-off processing to remove the photo resist (20) and the exchange-biasing material (22) and contact material (23) adhering thereto, to define a magnetoresistive sensor having a central sense region without exchange-biasing material and with exchange biasing material atomically coupled to the sensor outside the central sense region and contacts contacting the exchange biasing material.

10. A process as claimed in claim 9 characterised by including patterning the photo resist to cover a recess region on each side of the central sense region and patterning the magnetoresistive material and exchange-biasing material to define a magnetoresistive strip having a central sense region and two recess regions on each side of the central sense region without exchange-biasing material and with exchange-biasing material atomically coupled to the strip outside the central sense and recess regions.

**Patentansprüche**

1. Langgestreckter Magnetowiderstands-Sensor, dadurch gekennzeichnet, daß er einen in der Mitte liegenden Meßbereich und antiferromagnetisches Austauschvorspannungsmaterial (32, 34) aufweist, das mit dem Sensor lediglich außerhalb des in der Mitte liegenden Meßbereiches austauschgekoppelt ist.

2. Sensor nach Anspruch 1, dadurch gekennzeichnet, daß er einen Längsabschnitt, in dem der in der Mitte liegende Meßbereich mittig angeordnet ist, und zwei sich vertikal erstreckende Abschnitte (26, 28) aufweist, die mit dem Längsabschnitt außerhalb des in der Mitte liegenden Meßbereiches gekoppelt sind.

3. Sensor nach einem der vorhergehenden Ansprüche, dadurch gekennzeichnet, daß er eine pseudo-ellipsoidförmige Gestalt aufweist.

4. Sensor nach einem der vorhergehenden Ansprüche, dadurch gekennzeichnet, daß er eine Kante aufweist, und daß das Austauschvorspannungsmaterial (16, 18) über eine kurze Strecke (36) gegenüber dieser Kante zurückversetzt ist.

5. Sensor nach einem der vorhergehenden Ansprüche, dadurch gekennzeichnet, das er elektrische Kontakte einschließt, die mit dem Austauschvorspannungsmaterial (32, 34) in Kontakt stehen.

6. Sensor nach Anspruch 5, dadurch gekennzeichnet, daß die Kontakte parallele verkantete Oberfläche in dem in der Mitte liegenden Meßbereich aufweisen.

7. Sensor nach Anspruch 5, dadurch gekennzeichnet, daß die Kontakte unverkantete parallele Oberflächen in dem in der Mitte liegenden Meßbereich aufweisen.

8. Sensor nach einem der Ansprüche 5 bis 7, gekennzeichnet durch eine an jeden der Kontakte angeschaltete Konstantstromquelle (88) und eine Spannungsmeßschaltung (90) die weiterhin zwischen jeden der Kontakte angeschaltet ist.

9. Verfahren zur Herstellung eines Magnetowiderstands-Sensors, dadurch gekennzeichnet, daß es die folgenden Schritte umfaßt: Abscheiden einer dünnen Schicht aus Magnetowiderstands-Material (Mr) in einem Magnetfeld, Formung des Magnetowiderstands-Materials zur Bildung eines Sensorstreifens; Abscheiden einer Schicht (20) aus Fotoabdeckmaterial auf das Magnetowiderstands-Material, Formgebung des Fotoabdeckmaterials derart, daß es lediglich den in der Mitte liegenden Meßbereich überdeckt; Abscheiden einer Schicht aus antiferromagnetischem Austauschvorspannungsmaterial (22) auf dem Magnetowiderstands-Material und dem Fotoabdeckmaterial; Abscheiden einer Schicht aus Kontaktmaterial (23) und Abstreifbearbeitung zur Entfernung des Fotoabdeckmaterials und des daran anhaftenden Austauschvorspannungsmaterials (22) und des Kontaktmaterials (23), um einen Magnetowiderstands-Sensor mit einem in der Mitte liegenden Meßbereich ohne Austauschvorspannungsmaterial und mit Austauschvorspannungsmaterial, das mit dem Sensor außerhalb des in der Mitte liegenden Sensorbereiches atomgekoppelt ist, sowie mit Kontakten zu bilden, die mit dem Austauschvorspannungsmaterial in Kontakt stehen.

10. Verfahren nach Anspruch 9, gekennzeichnet durch den Einschluß des Schrittes der Formung des Fotoabdeckmaterials derart, daß ein Aussparungsbereich auf jeder Seite des in der Mitte liegenden Sensorbereichs abgedeckt wird, Formung des Magnetowiderstandsmaterials und des Austauschvorspannungsmaterials zur Bildung eines Magnetowiderstandsstreifens mit einem in der Mitte liegenden Meßbereich und zwei Aussparungsbereichen auf jeder Seite des in der Mitte liegenden Meßbereichs ohne Austauschvorspannungsmaterial und mit mit dem Streifen außerhalb der in der Mitte liegenden Meß- und Ausnehmungsbereiche atomgekoppeltem Austauschmaterial.

## Revendications

1. Capteur magnétorésistif allongé, caractérisé en ce qu'il comprend une région centrale de détection et un matériau anti-ferromagnétique (32, 34) à changement de polarisation accouplé pour les changements avec le capteur uniquement à l'extérieur de la région centrale de détection.

2. Capteur selon la revendication 1, caractérisé en ce qu'il comprend une partie longitudinale dans laquelle la région centrale de détection est centrée et une paire de parties (26, 28) orientées verticalement accouplées à la partie longitudinale à l'extérieur de la région centrale de détection.

3. Capteur selon l'une quelconque des revendications précédentes, caractérisé en ce que sa forme est pseudo-ellipsoïdale.

4. Capteur selon l'une quelconque des revendications précédentes, caractérisé en ce qu'il présente une arête, ledit matériau de changement de polarisation (16, 18) étant en retrait sur une courte distance (36) par rapport à ladite arête.

5. Capteur selon l'une quelconque des revendications précédentes, caractérisé en ce qu'il comprend des contacts électriques en contact avec ledit matériau de changement de polarisation (32, 34).

6. Capteur selon la revendication 5, caractérisé en ce que lesdits contacts ont des surfaces parallèles inclinées dans ladite région centrale de détection.

7. Capteur selon la revendication 5, caractérisé en ce que lesdits contacts ont des surfaces parallèles non inclinées dans la région centrale de détection.

8. Capteur selon l'une quelconque des revendications 5 à 7, caractérisé en ce qu'il comprend une source à courant constant (88) branchée entre chacun desdits contacts et un circuit détecteur de tension (90) branché en outre entre chacun desdits deux contacts.

9. Procédé de fabrication d'un capteur magnétorésistif, caractérisé en ce qu'il comprend les étapes suivantes : dépôt d'une mince couche de matériau magnétorésistif (Mr) dans un champ magnétique ; configuration du matériau magnétorésistif pour définir une bande de capteur ; dépôt sur le matériau magnétorésistif d'une couche (20) de photoréserve ; configuration de la couche de photoréserve pour qu'elle recouvre seulement une région centrale de détection ; dépôt d'une couche de matériau antiferromagnétique (22) de changement de polarisation sur le matériau magnétorésistif et sur la couche de photoréserve ; dépôt d'une couche de matériau de contact (23) ; et procédé de pelage pour retirer la couche de photoréserve (20) et le matériau de changement de polarisation (22) avec le matériau de contact (23) qui y adhère, pour définir un capteur magnétorésistif ayant une région de détection centrale sans matériau de changement de polarisation et avec un matériau de changement de polarisation couplé atomiquement au capteur à l'extérieur de la région centrale de détection et des contacts en contact avec le matériau de changement de polarisation.

10. Procédé selon la revendication 9, caractérisé en ce qu'il comprend la configuration de la couche de photoréserve pour qu'elle recouvre une région en retrait de chaque côté de la région centrale de détection et la configuration du matériau magnétorésistif et du matériau à changement de polarisation pour définir une bande magnetorésistive ayant une région centrale de détection et deux régions en retrait de chaque côté de la région centrale de détection sans matériau à changement de polarisation et avec un matériau à changement de polarisation accouplé à la bande en dehors de la région centrale de détection et des régions en retrait.

FIG. 1

FIG. 4

FIG. 2

FIG. 3

FIG. 5

OXIDE

SHIELD POLE

SPACER

CONTACT

EXCHANGE

MR

SPACER

SHIELD POLE

OXIDE

38

32

52

10

42

40

36

44

50

MAGNETIC DISK

DIRECTION OF ROTATION

EP 0 279 537 B1

12

FIG. 6

PERMALLOY

COILS

POLYIMIDE

OXIDE

PERMALLOY

POLYMIDE

OXIDE

MR

OXIDE

Ni Zn FERRITE

METAL CONTACTS

EP 0 279 537 B1

EP 0 279 537 B1

TRACK
WIDTH

PERMALLOY
POLE  TIP — 79

PERMALLOY POLE TIP ⌐72

CONTACTS — ⌐L — 65 — 66

MR — 64

FERRITE — 60

FIG. 7

FIG. 8

FIG. 9

FIG. 10

In Linear Mode The Data Input Pulse
Passes Through States 1,2,3,4. The
Output Responds By Moving Through
States 1,2,3,4. At All Pts, The Input
And Output Are Linear Replications.

In The "Non Linear" Mode The Input
Successively Passes Through States A → F.
The Output Responds By Moving Through
States A' → F'. However The Output Response
Is Not Linear Until D' → F' Where It Again
Becomes A Linear Replication Of The
Input D → F.

FIG. 11

FIG. 12